# DEMANDE DE BREVET EUROPEEN

(11) **EP 1 351 307 A1**
(43) Date de publication de la demande: **08.10.2003**
(21) Numéro de dépôt: 02405247.4
(22) Date de dépôt: 28.03.2002
(51) Int. Cl.: H01L 27/108, G11C 11/404

(54) **Procédé de commande d'un dispositif semi-conducteur**

(71) Demandeur: Innovative Silicon SA, 1015 Lausanne (CH); Ecole Polytechnique Fédérale de Lausanne (EPFL), 1015 Lausanne (CH)
(72) Inventeur: Fazan, Pierre, 2525 Le Landeron (CH); Okhonin, Serguei, 1005 Lausanne (CH)
(74) Mandataire: Vinsome, Rex Martin

(57) **Abrégé**

L'invention concerne un procédé de commande d'un dispositif semiconducteur destiné à stocker une charge électrique formée d'un ensemble de particules (24) d'une polarité donnée, comportant un transistor à effet de champ qui comprend un corps (20) à l'intérieur duquel est stockée cette charge.

L'élimination de la charge stockée se fait par recombinaison, dans le corps (20), des particules stockées avec des particules de polarité inverse.

## Description

La présente invention concerne un procédé de commande d'un dispositif semi-conducteur dans lequel une charge électrique est stockée. Plus précisément, ce dispositif est du type comportant un substrat muni d'une couche isolante et, formé sur celle-ci, au moins un composant, par exemple un transistor à effet de champ comprenant une source, un drain, un corps interposé entre la source et le drain, une grille jouxtant le corps et un film diélectrique interposé entre la grille et le corps. La demande de brevet EP 01810587.4 décrit en détail un tel dispositif qui peut être une mémoire DRAM (de l'anglais " Dynamic Random Access Memory), embarquée (généralement identifiée par le terme anglais « embedded » et notée e-DRAM), ou non, ou un capteur.

Les mémoires DRAM de ce type comportent un circuit de commande et des cellules disposées dans une structure matricielle, chaque cellule étant constituée d'un transistor à effet de champ du type mentionné ci-dessus. Selon les potentiels appliqués à ses bornes, un canal électriquement conducteur se forme entre la source et le drain, à l'interface du corps avec le film ou la couche isolante adjacent à la grille.

Comme expliqué dans la demande de brevet EP précitée, il est possible de créer dans le corps une charge électrique, formée d'un ensemble de particules chargées (électrons ou trous), qui y est alors stockée, tout en présentant une lente décroissance, De manière classique pour une mémoire binaire de type DRAM, ses deux états « 0 » et « 1 » sont fonction de la charge créée. Selon l'exemple fourni dans le document, l'état « 1» correspond à la présence, dans le corps, d'une charge électrique nette positive et l'état « 0 » à la présence d'une charge nette négative. Ces charges sont crées dans la cellule par des impulsions électriques appliquées aux bornes des transistors par le circuit de commande. Dans le cas d'un transistor de type NMOS, la charge nette positive correspond à un excès de trous, alors qu'il y a absence de trous lorsque la charge nette est négative. S'il s'agit d'un transistor de type PMOS, il y aura alors excès ou absence d'électrons.

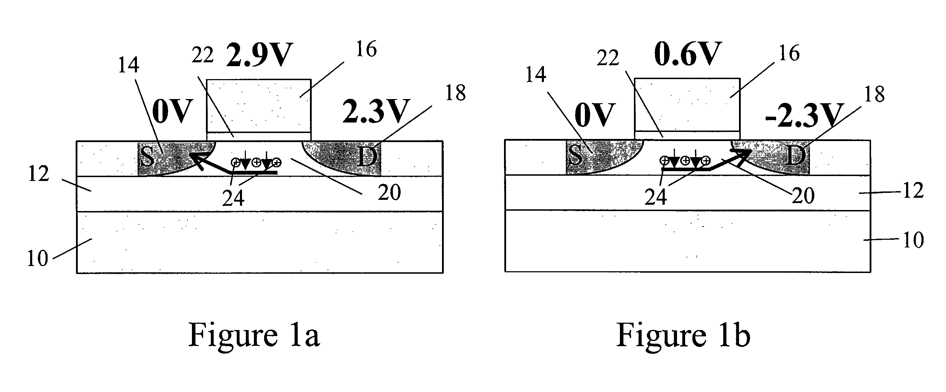

Les figures 1a et 1b représentent deux variantes d'un procédé de commande connu, appliqué à un transistor de type PD-SOI NMOS. Ce dernier comporte, de manière classique, un substrat 10, une couche isolante 12 recouvrant le substrat, une source 14, une grille 16, un drain 18 et un corps 20. La source 14, le corps 20 et le drain 18 sont disposés dans un même plan, réalisés par dopage d'une couche semi-conductrice. La grille 16, qui recouvre le corps 20, en est séparée par un film diélectrique 22.

Dans le circuit de la figure 1a, qui présente un transistor NMOS, une charge nette négative est créée par extraction de trous du corps 20 vers la source 14, en appliquant des impulsions de 2,3 V sur le drain 18 et de 2,9 V sur la grille 16, durant un temps de l'ordre de 3 ns, la source étant à 0 V. Le potentiel positif de la grille 16 crée un canal d'électrons entre la source 14 et le drain 18. Les potentiels élevés sur la grille 16 et le drain 18 augmentent le potentiel du corps 20, de telle sorte que les trous contenus dans le corps 20 migrent, en profondeur, vers la source 14.

Dans le circuit de la figure 1b, la charge nette négative est créée par extraction des trous du corps 20 vers le drain 18, en appliquant des impulsions de -2,3 V sur le drain 18 et de 0,6 V sur la grille 16, durant un temps de l'ordre 3 ns, la source étant à 0 V. Ici aussi, la migration se fait en profondeur. Dans ces deux variantes, la création d'une charge nette négative est réalisée par évacuation de trous dans un mode de fonctionnement qui fait conduire le transistor, ce qui implique une consommation importante d'énergie.

Le même problème se pose lorsque le dispositif semi-conducteur est un capteur, sa charge variant alors en fonction du temps et d'un paramètre physique à mesurer.

Le but de la présente invention est donc de réduire, de manière drastique, l'énergie nécessaire à la création d'une charge dans le dispositif semi-conducteur.

De façon plus précise, l'invention concerne un procédé de commande d'un dispositif semi-conducteur dans lequel est stocké une charge électrique formée d'un ensemble de particules chargées électriquement, comportant un substrat muni d'une couche isolante et, formé sur celle-ci, au moins un composant qui comprend un corps isolé électriquement, à l'intérieur duquel la charge est stockée. Dans ce procédé, pour réduire la charge électrique stockée, les particules stockées sont recombinées, dans le corps, avec des particules de polarité inverse.

Le procédé défini ci-dessus fait donc appel au phénomène physique connu sous le nom de recombinaison de charges, tel que décrit, par exemple, dans l'ouvrage intitulé : " Physics of Semiconductors Devices ", S. M. Sze, ISBN 0-471-05661-8. De la sorte, les courants mis en jeu, et donc l'énergie nécessaire, sont extrêmement faibles.

Ce procédé est particulièrement bien adapté lorsque le composant est un transistor à effet de champ qui comprend, en outre, une source, un drain, le corps étant interposé entre la source et le drain, une grille jouxtant le corps et un film diélectrique interposé entre la grille et le corps. Pour neutraliser la charge stockée, le procédé comprend:
- une première phase durant laquelle est créée une première différence de potentiel entre la grille, d'une part, et le drain et la source, d'autre part, de manière à former, à l'interface du corps avec le film ou la couche, entre le drain et la source, un canal électriquement conducteur contenant des particules libres de polarité inverse de celle des particules stockées, puis
- une deuxième phase durant laquelle est créée une deuxième différence de potentiel entre la grille, d'une part, et le drain et la source, d'autre part, de manière à supprimer le canal et à maintenir une partie au moins des particules libres dans l'interface, et y faire migrer les particules de la charge pour qu'elles s'y recombinent avec les particules libres.

Dans une première variante de mise en oeuvre du procédé pour effectuer la commande d'un dispositif dans lequel le film et le corps forment ensemble une interface présentant des défauts structurels formant des pièges à particules, les première et deuxième phases se répètent de manière cyclique, autant de fois que nécessaire, en fonction de la charge stockée et de la quantité de pièges que comporte l'interface, typiquement entre 1 et 1000 fois. Lorsque la charge stockée est éliminée du corps, les pièges ne captent donc plus de nouvelles particules, et le procédé sature.

Afin de réduire la consommation, les potentiels de la source et du drain sont égaux, tant durant la première que la deuxième phase du cycle.

Il est apparu, en effet, qu'en procédant ainsi, durant la première phase, des particules libres de la source et du drain migrent dans le canal, à l'interface du corps et du film diélectrique, et sont piégées par des puits de potentiels que forment des défauts présents dans cette interface. Durant la deuxième phase, les particules stockées dans le corps migrent vers l'interface et se recombinent avec les particules piégées, de telle sorte que la charge stockée tend à diminuer. Ainsi, le courant peut être limité à la seule migration de particules destinées à éliminer les particules de la charge stockée dans le corps.

La présente invention concerne également un dispositif semi-conducteur destiné à la mise en oeuvre du procédé défini ci-dessus. Dans ce dispositif, l'interface, que forment ensemble le film diélectrique et le corps du transistor, présente une densité de pièges typiquement comprise entre 10⁹ et 10¹² par cm². Une telle densité permet d'éviter que les défauts n'affectent le bon fonctionnement du dispositif, tout en nécessitant un nombre acceptable de cycles.

Une telle procédure est connue sous le terme anglais de " charge pumping ". Elle est décrite dans l'article de G. Groeseneken et al., intitulé « A reliable approach to charge pumping measurements in MOS transistors », IEEE Transaction on Electron Devices, Vol. 31, pp. 42-53, 1984. A ce jour, elle a été utilisée seulement pour déterminer les défauts que peuvent présenter des interfaces, par exemple, entre le corps et le film diélectrique, dans des transistors de type « bulk », c'est à dire sans couche isolante.

Dans une deuxième variante de mise en oeuvre du procédé selon l'invention, le passage de la première à la deuxième phase se fait en un temps de commutation inférieur au temps de migration des particules contenues dans le canal, de ce dernier vers la source et le drain, de manière à ce que les particules se trouvant dans le canal au moment de la commutation puissent se recombiner avec les particules de polarité inverse stockées dans le corps.

Le temps de commutation entre le premier et le deuxième signal doit donc être extrêmement bref, de manière à ce que les particules se trouvant dans le canal au moment de la commutation n'aient pas le temps de migrer vers la source ou le drain avant qu'elles rencontrent les particules de polarité inverse stockées dans le corps. Pour un dispositif faisant appel à une technologie de type 0,25 µm, le temps de commutation est de quelques picosecondes à quelques dizaines de picosecondes. Ce temps est encore réduit avec des technologies de type inférieur à 0,25 µm.

D'autres caractéristiques de l'invention ressortiront de la description qui va suivre, faite en regard du dessin annexé, dans lequel:
- les figures 1a et 1b représentent, de manière schématique, des modes de commande connus, pour éliminer la charge stockée dans le corps d'un transistor, et
- les figures 2a, 2b et 2c, d'une part, 3a, 3b, 3c et 3d, d'autre part, illustrent deux variantes de mise en oeuvre du procédé selon l'invention.

Les figures 1a et 1b ont fait, ci-dessus, l'objet d'une description montrant que les procédés connus tendant à éliminer la charge stockée dans un corps de transistor consomment une quantité relativement importante d'énergie.

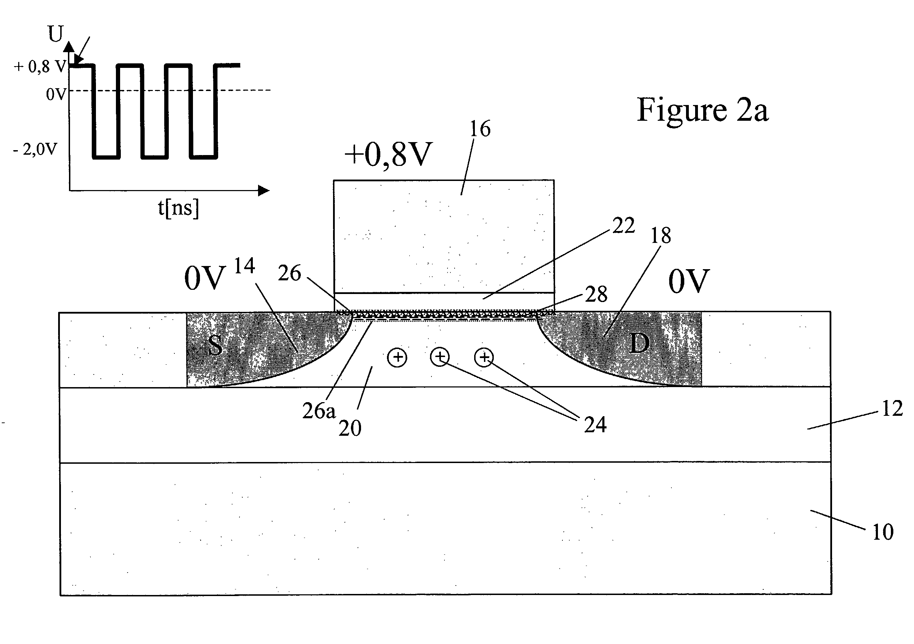

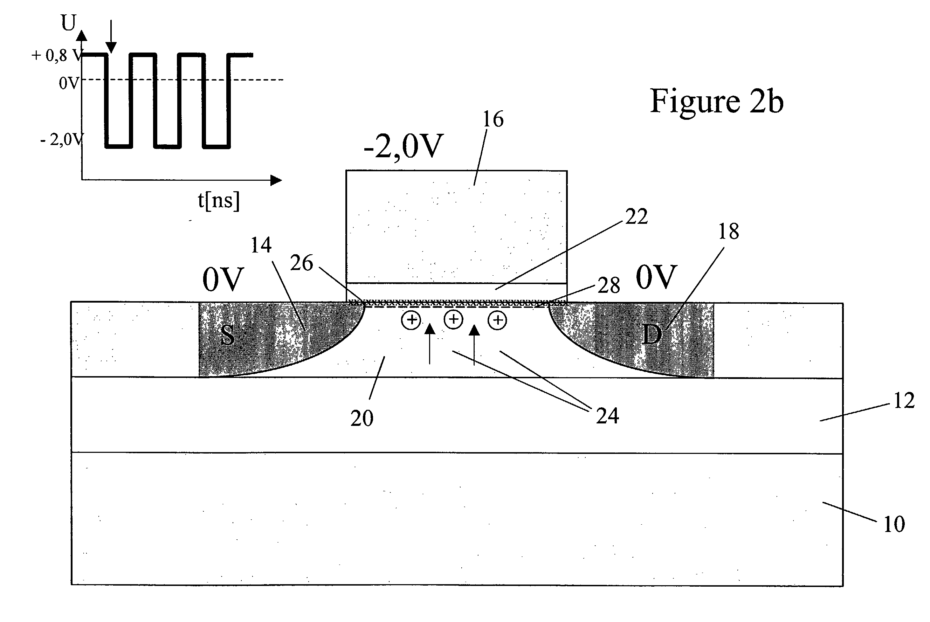

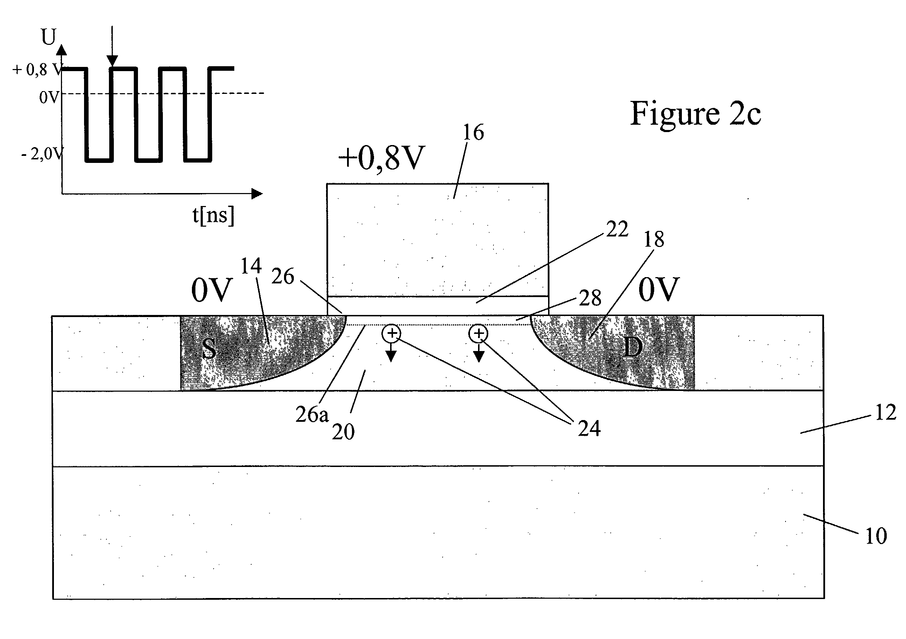

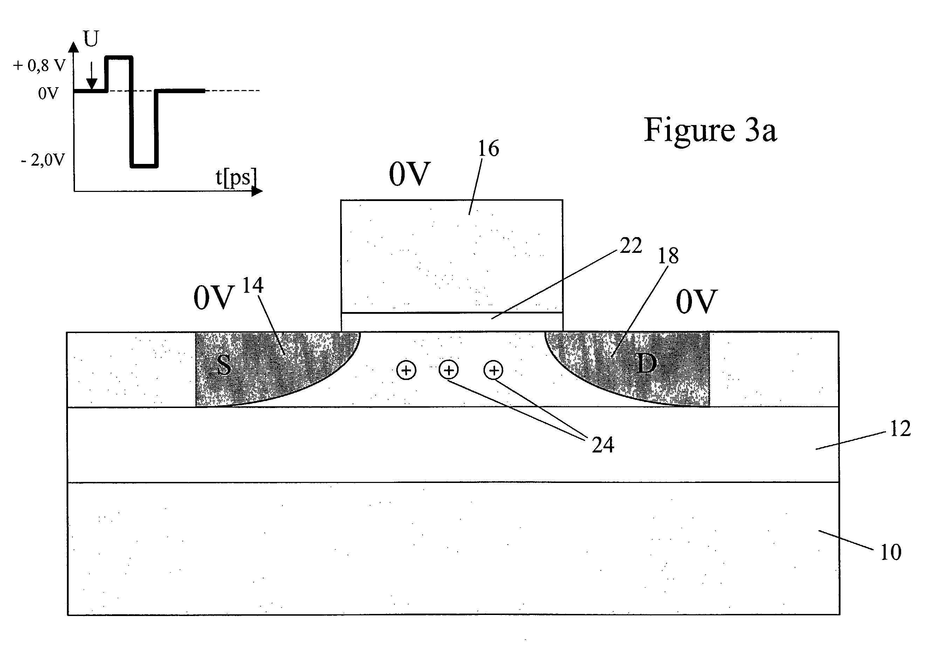

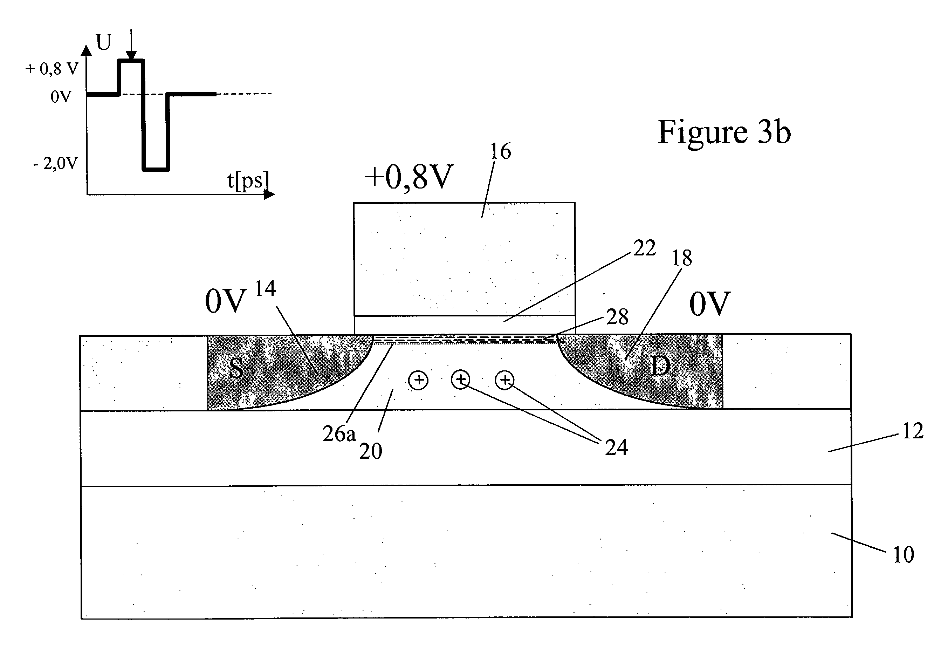

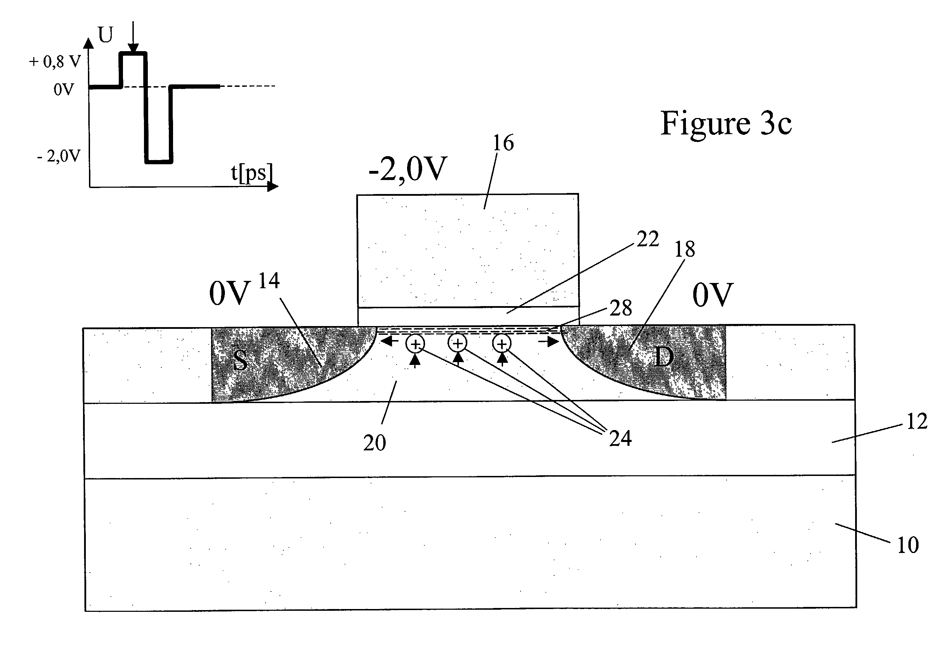

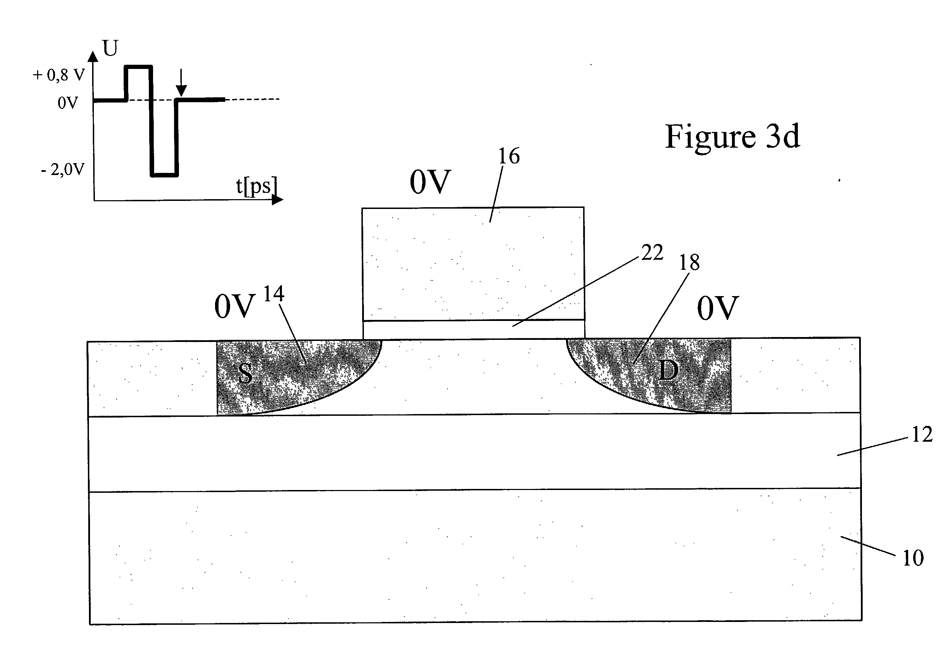

Sur les figures 2 et 3, on retrouve, à chaque fois, un même transistor comportant aussi un substrat 10 en silicium monocristallin, une couche isolante 12 en SiO₂, une source 14, une grille 16, un drain 18 et un corps 20, la source 14, le drain 18 et le corps 20 étant disposés dans une même couche de matériau semi-conducteur, par exemple du silicium et différentiés les uns des autres par dopage. La grille 16 et le corps 20 du transistor sont séparés par un film diélectrique 22 en SiO₂. Celui-ci et la grille 16 débordent légèrement sur la source 14 et le drain 18.

Le transistor est de type PD-SOI NMOS, par exemple en technologie 0,25 µm. Dans cette appellation l'abréviation « PD » vient de l'anglais « Partially Depleted ». Son corps peut stocker des particules positives, c'est à dire des trous 24.

Un tel transistor peut aussi bien être utilisé comme capteur, auquel cas il pourra travailler seul ou en matrice, que comme cellule d'une mémoire de type DRAM ou e-DRAM, auquel cas il est associé à d'autres transistors formant ensemble une matrice, à raison d'un transistor par point de la matrice.

Comme expliqué dans la demande de brevet EP précitée, ce type de transistor peut être commandé de manière à ce qu'il stocke une charge électrique. Dans l'application relative aux capteurs, le niveau de cette charge est significatif de la mesure effectuée. Utilisé comme cellule d'une mémoire, le transistor peut être considéré comme susceptible d'occuper deux états logiques « 0 » et « 1 », l'état « 0 » correspondant à une charge nette négative correspondant à une absence de charge dans le corps, l'état « 1 » à l'existence de cette charge, laquelle est positive, c'est à dire formée de trous, dans un transistor de type NMOS.

Dans le mode de réalisation de la figure 2, il est important que le corps 20 et le film 22 soient séparés par une interface 26 ayant une épaisseur de quelques couches atomiques et présentant des défauts destinés à former, comme cela sera expliqué plus loin, des pièges pouvant fixer des électrons.

Pour écrire un « 0 », il faut donc éliminer la charge stockée dans le corps 20, ce qui se fait en appliquant un signal cyclique, représenté au haut des figures en montrant, en fonction du temps, la tension appliquée à la grille 16. L'instant considéré est marqué d'une flèche sur ce diagramme.

Durant toute l'opération, la source 14 et le drain 18 peuvent être à un potentiel nul.

Au début du cycle, et comme on peut le voir sur la figure 2a, un potentiel de + 0,8 V est appliqué sur la grille 16, ce qui a pour effet de créer, à l'interface 26, un canal 26a conducteur, comportant une forte densité de particules négatives, soit des électrons 28, dont certains sont piégés par les défauts de l'interface 26.

En appliquant une tension de - 2,0 V sur la grille 16, comme indiqué sur la figure 2b, le canal disparaît, mais les électrons 28 piégés restent dans l'interface 26. Par ailleurs, la tension appliquée sur la grille 16 tend à faire migrer les trous 24 de la charge vers l'interface 26 où ils se recombinent avec les électrons piégés 28.

Comme on peut le voir sur la figure 2c, un nouveau cycle débute par l'application d'une tension de + 0,8 V sur la grille 16, constituant une nouvelle fois le canal 26a. Comparativement à la situation de la figure 2a, le nombre de trous 24 a diminué. Cette diminution est d'autant plus importante que l'interface comporte de défauts. De manière typique, il est avantageux que la densité de défauts soit comprise entre 10⁹ et 10¹² par centimètre carré. Avec une telle densité, le nombre de défauts et le nombre de cycles nécessaires à l'élimination des particules formant la charge stockée présentent un compromis acceptable.

La durée d'un cycle est, typiquement, d'environ 10 nanosecondes, les temps de montée et de descente étant de l'ordre de la nanoseconde.

On peut noter que, dans certains modes de réalisation de tels transistors, il est aussi possible qu'un canal se forme entre la source 14 et le drain 18 au voisinage de la couche isolante 12. Les conditions de recombinaison diffèrent un peu, mais le principe reste le même.

Les figures 3a à 3d représentent un transistor identique à celui de la figure 2. Dans ce mode de réalisation, l'élimination de la charge stockée dans le corps est effectuée de manière beaucoup plus rapide, en faisant appel à une recombinaison des charges à l'interface 26, mais sans que les électrons soient piégés.

La figure 3a montre l'état dans lequel se trouve le transistor avant que le processus d'élimination de la charge soit mis en oeuvre. Dans cet état, le corps 20 comporte un excès de trous 24. En appliquant une tension positive, par exemple de 0,8V, sur la grille 16, comme indiqué sur la figure 3b, la source 14 et le drain 18 pouvant être à 0V, il se crée un canal 26a à l'interface 26. Il existe, dans ce canal, un excès d'électrons 28, dépendant de la tension appliquée à la grille 16, la quantité d'électrons libres 28 dépassant largement celle des trous 24 présents dans le corps.

Il a été constaté qu'en commutant très rapidement le signal appliqué à la grille 16, la tension passant brusquement de + 0,8V à - 2V, en un temps de l'ordre de la picoseconde, les électrons 28 se trouvant dans le canal 26a n'ont pas le temps de migrer avant que les trous 24 contenus dans le corps arrivent dans l'espace du canal 26a (Figure 3c). Les trous 24 et les électrons 28 se recombinent donc à l'intérieur même du corps, sans qu'il y ait à faire circuler un courant entre la source et le drain, alors que le surplus d'électrons 28 migre vers la source 14 et le drain 18. De la sorte, après un laps de temps extrêmement court, tous les trous 24 de la charge stockée sont recombinés, comme représenté sur la figure 3d.

On relèvera que, pour atteindre de telles vitesses de commutation, il est nécessaire de réduire au minimum les résistances et les capacités parasites des circuits et des lignes de commande. Dans le cas des mémoires, cela peut impliquer une limitation du nombre de transistors par ligne et par colonne. Cet inconvénient est largement compensé par une importante accélération du processus d'élimination de la charge stockée.

Toute la description faite ci-dessus se rapporte à des transistors de type NMOS. Il va de soi que les mêmes principes peuvent être appliqués à des transistors de type PMOS, la charge stockée étant alors négative, c'est à dire formée d'électrons, alors que les particules libres dans le canal sont des trous. Dans ce cas, le canal est engendré par l'application d'un potentiel négatif sur la grille.

Dans certaines structures de transistors SOI, tant de type NMOS que PMOS, le substrat peut aussi jouer le rôle de grille. Dans ce cas, la couche isolante assure alors la fonction de film diélectrique. De la sorte le canal se forme à l'interface du corps et de la couche isolante.

## Revendications

1. Procédé de commande d'un dispositif semi-conducteur dans lequel est stockée une charge électrique formée d'un ensemble de particules chargées électriquement, comportant un substrat (10) muni d'une couche isolante (12) et, formé sur celle-ci, au moins un composant qui comprend un corps isolé (20), à l'intérieur duquel la charge est stockée, **caractérisé en ce que**, pour réduire la charge électrique, lesdites particules sont recombinées, dans le corps (20), avec des particules de polarité inverse.

2. Procédé selon la revendication 1, **caractérisé en ce que** ledit composant est un transistor à effet de champ qui comprend, en outre, une source (14), un drain (18), le corps (20) étant interposé entre la source (14) et le drain (18), une grille (16) jouxtant le corps et un film diélectrique (22) interposé entre la grille (16) et le corps (20), **caractérisé en ce qu'**il comprend , pour neutraliser ladite charge:
- une première phase durant laquelle est créée une première différence de potentiel entre la grille (16), d'une part, et le drain (18) et la source (14), d'autre part, de manière à former, à l'interface du corps (20) avec le film (22) ou la couche (12), entre le drain (18) et la source (14), un canal (26a) électriquement conducteur contenant des particules libres (28) de polarité inverse de celle des particules stockées (24), puis
- une deuxième phase durant laquelle est créée une deuxième différence de potentiel entre la grille (16), d'une part, et le drain (18) et la source (14), d'autre part, de manière à supprimer ledit canal (26a) et à maintenir une partie au moins desdites particules libres (28) dans ledit interface, et y faire migrer les particules (24) de ladite charge pour qu'elles s'y recombinent avec les particules libres (28).

3. Procédé selon la revendication 2, pour la commande d'un dispositif dans lequel le film diélectrique (22) et le corps (20) forment ensemble une interface (26) présentant des défauts structurels, **caractérisé en ce que** les première et deuxième phases se répètent de manière cyclique.

4. Procédé selon la revendication 3, **caractérisé en ce que** le nombre de cycles est compris entre 1 et 1000.

5. Procédé selon l'une des revendications 3 et 4, **caractérisé en ce que**, tant durant la première que la deuxième phase du cycle, les potentiels de la source (14) et du drain (18) sont égaux.

6. Dispositif semi-conducteur destiné à la mise en oeuvre du procédé selon l'une des revendications 3 à 5, **caractérisé en ce que** l'interface (26) que forment ensemble le film diélectrique (22) et le corps (20) présente une densité de défauts typiquement comprise entre 10⁹ et 10¹² par cm².

7. Procédé selon la revendication 2, **caractérisé en ce que** le passage de la première à la deuxième phase se fait dans un temps de commutation inférieur au temps de migration des particules libres (28) contenues dans le canal (26a), de ce dernier (26a) vers la source (14) et le drain (18), de manière à ce que les particules (28) se trouvant dans le canal au moment de la commutation se recombinent avec les particules (24) de polarité inverse contenues dans le corps (20).

8. Procédé selon la revendication 7, **caractérisé en ce que** le temps de commutation est inférieur à quelques picosecondes dans un dispositif réalisé en technologie de type inférieur ou égal à 0,25 µm
